# FASCICULE DE BREVET EUROPEEN

(11) **EP 3 276 364 B1**
(45) Date de publication et mention de la délivrance du brevet: **04.09.2019**
(21) Numéro de dépôt: 17181312.4
(22) Date de dépôt: 13.07.2017
(51) Int. Cl.: G01R 31/36, H01M 10/48, H01M 10/42, H01M 10/44, G01R 31/382, G01R 31/392, G01R 31/396

(54) **PROCÉDÉ DE DÉTERMINATION DE L'ÉTAT DE SANTÉ DES CELLULES D'UNE BATTERIE**
VERFAHREN ZUR BESTIMMUNG DES GESUNDHEITSZUSTANDS DER ZELLEN EINER BATTERIE
METHOD FOR DETERMINING THE STATE OF HEALTH OF THE CELLS OF A BATTERY

(30) Priorité: 29.07.2016 FR 1657350
(43) Date de publication de la demande: 31.01.2018
(73) Titulaire: Commissariat à l'Energie Atomique et aux Energies Alternatives, 75015 Paris (FR)
(72) Inventeur: VINIT, Laurent, 73370 LE BOURGET DU LAC (FR); MONTARU, Maxime, 15170 JOURSAC (FR); CROUZEVIALLE, Bruno, 73100 PUGNY-CHATENOD (FR); HING, Sothun Eric, 73000 CHAMBERY (FR)
(74) Mandataire: Cabinet Beaumont

(56) Documents cités:
- WO-A1-2015/162259
- US-A1- 2015 260 795
- US-A1- 2015 377 976

## Description

### Domaine

La présente demande concerne le domaine des batteries électriques de façon générale, et vise plus particulièrement la détermination de l'état de santé ou état de vieillissement des cellules d'une batterie.

### Exposé de l'art antérieur

Une batterie électrique est un groupement de plusieurs cellules rechargeables reliées en série et/ou en parallèle entre deux noeuds ou bornes de fourniture de tension.

Dans certaines applications, on souhaite pouvoir estimer, pour chaque cellule d'une batterie, un indicateur représentatif du vieillissement de la cellule, généralement appelé SOH, de l'anglais "State of Health" pour état de santé. A un instant donné de la vie d'une cellule, le SOH peut être défini comme étant le rapport de la capacité de la cellule (c'est-à-dire la charge maximale qu'est capable de stocker la cellule) à l'instant considéré, sur une capacité de référence de la cellule, par exemple sa capacité nominale (c'est-à-dire la capacité indiquée par le constructeur), ou sa capacité mesurée à l'état neuf.

La connaissance du SOH de chaque cellule peut par exemple permettre d'identifier des cellules défectueuses pour les isoler ou les remplacer, ou de recaler ou réajuster les jauges d'état de charge des cellules pour tenir compte du vieillissement des cellules.

Les techniques connues de détermination du SOH d'une cellule passent par la mesure de la capacité de cette cellule. Pour cela, la cellule peut être rechargée jusqu'à son niveau de pleine charge puis complètement déchargée jusqu'à son seuil de fin de décharge, ou déchargée jusqu'à son seuil de fin de décharge puis complètement rechargée jusqu'à son niveau de pleine charge. Lors de la phase de décharge complète ou de recharge complète de la cellule, la charge extraite de la cellule ou injectée dans la cellule est mesurée par comptage coulométrique de façon à mesurer la capacité réelle de la cellule. Connaissant la capacité réelle de la cellule, le SOH peut être calculé en divisant cette capacité réelle par la capacité de référence de la cellule. En pratique, pour mettre en oeuvre un tel procédé, la cellule que l'on souhaite diagnostiquer doit être isolée des autres cellules de la batterie, notamment pour s'assurer que la cellule puisse atteindre son seuil de fin de décharge ou son seuil de pleine charge sans être limitée par les autres cellules de la batterie. Il en résulte que cette méthode est relativement contraignante à mettre en oeuvre.

D'autres méthodes de détermination du SOH ont été proposées, par exemple des méthodes basées sur la spectroscopie d'impédance électrochimique, des méthodes basées sur des techniques d'intelligence artificielle à base d'algorithmes d'apprentissage probabilistes, ou encore des méthodes basées sur des modélisations mathématiques du comportement des batteries. Ces méthodes sont toutefois complexes et coûteuses à mettre en oeuvre.

Les documents US2015/260795, WO2015/162259 et US2015/377976 décrivent également des méthodes de détermination du SOH des cellules d'une batterie.

### Résumé

Ainsi, un mode de réalisation prévoit un procédé, selon la revendication 1, de détermination de l'état de santé des cellules d'une batterie comportant une pluralité de cellules reliées en série, ce procédé comportant les étapes suivantes : pendant une phase de décharge ou de charge de la batterie, mesurer et mémoriser l'évolution de la tension aux bornes de chaque cellule ; et lorsque une première cellule atteint une condition prédéfinie de fin de décharge ou de fin de charge, interrompre la décharge ou la charge de la batterie, et déterminer, pour chaque autre cellule, la variation de charge ΔQ_{Ci} subie par la batterie entre : - le passage de la première cellule à une tension égale à la tension de l'autre cellule à la fin de la phase de décharge ou de charge de la batterie, et - la fin de la phase de décharge ou de charge de la batterie.

Selon un mode de réalisation, le procédé comporte en outre la fourniture, pour chaque autre cellule de la batterie, d'une valeur estimée de la capacité de la cellule égale à Qₜₒₜ+ΔQ_{Ci}, Qₜₒₜ étant la charge extraite de la batterie ou injectée dans la batterie entre le début et la fin de la phase de décharge ou de charge de la batterie.

Selon un mode de réalisation, le procédé comporte en outre la fourniture, pour chaque autre cellule de la batterie d'un indicateur d'état de santé de la cellule calculé en tenant compte de la valeur estimée de la capacité Qₜₒₜ+ΔQ_{Ci} de la cellule.

Selon un mode de réalisation, le procédé comprend en outre : préalablement à la phase de décharge, une étape de charge de la batterie jusqu'à un seuil de pleine charge ; ou préalablement à la phase de charge, une étape de décharge de la batterie jusqu'à un seuil de décharge.

Selon un mode de réalisation, l'étape préalable de charge ou de décharge de la batterie comporte un équilibrage des cellules de la batterie.

Selon un mode de réalisation, lors de la phase de décharge ou de charge de la batterie, l'évolution de la charge extraite de la batterie ou injectée dans la batterie est mesurée par un dispositif de comptage de charge connecté aux bornes de la batterie.

Selon un mode de réalisation, le dispositif de comptage de charge comprend un compteur coulométrique ou un intégrateur de courant.

Selon un mode de réalisation, lors de la phase de décharge ou de charge de la batterie, l'évolution de la charge extraite de la batterie ou injectée dans la batterie est estimée à partir du temps écoulé depuis le début de la phase de décharge ou de charge et du courant de décharge de la batterie.

Selon un mode de réalisation, il est tenu compte de l'évolution des températures des cellules lors de la phase de décharge ou de charge de la batterie dans la détermination de l'état de santé des cellules, par exemple pour corriger la mesure de capacité réalisée. A titre d'exemple, un facteur correctif peut être appliqué à la valeur estimée de la capacité réelle de chaque cellule, ce facteur pouvant être déterminé à partir de la température mesurée de la cellule pendant la phase de décharge ou de charge de la batterie. A titre d'exemple, le facteur correctif est issu d'une cartographie de la charge en fonction du courant et de la température, tel que décrit dans la demande de brevet français FR2994339.

Un autre mode de réalisation prévoit un procédé, selon la revendication 8, de revalorisation de cellules de batterie usagées comportant une étape de diagnostic des cellules mettant en oeuvre un procédé tel que défini ci-dessus.

Selon un mode de réalisation, le procédé de revalorisation comporte en outre une étape de sélection de cellules dont l'indicateur d'état de santé satisfait une condition prédéfinie, et une étape d'assemblage des cellules sélectionnées en une nouvelle batterie.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est un diagramme représentant l'évolution de la tension aux bornes de cellules d'une batterie en fonction de la quantité de charge extraite de la batterie lors d'une phase de décharge de la batterie ; et
la figure 2 est un logigramme illustrant, sous forme de blocs, un exemple d'un mode de réalisation d'un procédé de détermination de l'état de santé de cellules d'une batterie.

### Description détaillée

De mêmes éléments ont été désignés par de mêmes références aux différentes figures. Par souci de clarté, seuls les éléments qui sont utiles à la compréhension des modes de réalisation décrits ont été représentés et sont détaillés. En particulier, les diverses utilisations qui peuvent être faites du SOH des cellules d'une batterie n'ont pas été détaillées. Sauf précision contraire, les expressions "approximativement", "environ", "sensiblement", et "de l'ordre de" signifient à 10 % près, de préférence à 5 % près.

On s'intéresse ici plus particulièrement à la détermination du SOH des cellules d'une batterie comportant plusieurs cellules reliées en série entre une borne positive et une borne négative de la batterie. Les cellules de la batterie sont de préférence identiques aux dispersions de fabrication et de vieillissement près. Chaque cellule peut comporter une unique cellule élémentaire de type pile, accumulateur, etc., ou plusieurs cellules élémentaires reliées en série et/ou en parallèle entre une borne positive et une borne négative de la cellule. Les cellules élémentaires sont par exemple des cellules au lithium, par exemple des cellules de type lithium-ion, lithium-ion-polymère, lithium-métal-polymère, etc. Plus généralement, les modes de réalisation décrits s'appliquent à toutes ou à la plupart des technologies de cellules élémentaires de batterie connues.

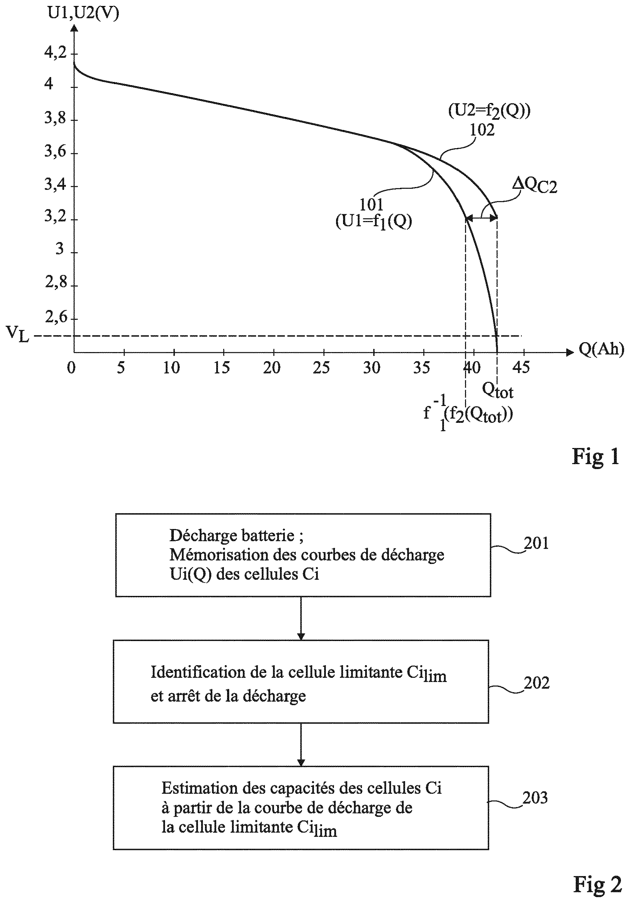

La figure 1 est un diagramme représentant schématiquement, pour une batterie constituée de deux cellules C1 et C2 (non représentées) connectées en série, l'évolution, lors d'une phase de décharge complète de la batterie, de la tension (en volts, en ordonnée) aux bornes des cellules, en fonction de la charge (en ampère-heure, en abscisse) extraite de la batterie. Plus particulièrement, le diagramme de la figure 1 comprend une courbe 101 représentant l'évolution de la tension U1 aux bornes de la cellule C1 en fonction de la charge Q extraite de la batterie, et une courbe 102 représentant l'évolution de la tension U2 aux bornes de la cellule C2 en fonction de la charge Q extraite de la batterie. L'évolution de la tension U1 est régie par une fonction f₁ telle que U1=f₁(Q), et l'évolution de la tension U2 est régie par une fonction f₂ telle que U2=f₂(Q).

Au début de la phase de décharge (Q=0), la batterie est pleinement chargée. Les tensions U1 et U2 ont sensiblement le même niveau correspondant à la tension de pleine charge des cellules C1 et C2, de l'ordre de 4,1 V dans l'exemple représenté. Au fur et à mesure de la décharge, les tensions U1 et U2 des cellules C1 et C2 décroissent de façon monotone en fonction de la charge Q extraite de la batterie. La décharge s'interrompt lorsqu'une première cellule, appelée cellule limitante, atteint un seuil de tension basse V_{L} prédéfini, correspondant par exemple à un seuil critique de décharge à ne pas dépasser sous peine d'endommager la cellule (de l'ordre de 2,5 V dans l'exemple représenté). A titre d'exemple, la tension limite basse V_{L} est définie par le fabricant des cellules. La tension V_{L} est par exemple identique pour toutes les cellules de la batterie. Dans l'exemple représenté, la cellule limitante de la batterie est la cellule C1 (courbe 101). A l'instant où la cellule limitante C1 atteint son seuil de fin de décharge V_{L}, la charge Qₜₒₜ extraite de la batterie depuis le début de la phase de décharge correspond à la capacité réelle de la cellule limitante C1, qui définit la capacité de la batterie. Connaissant cette capacité Qₜₒₜ, le SOH de la cellule limitante C1 peut être calculé, par exemple en calculant le rapport de cette capacité Qₜₒₜ sur une capacité de référence de la cellule.

Selon un aspect d'un mode de réalisation, on prévoit d'utiliser la courbe de décharge de la cellule limitante de la batterie pour estimer la capacité réelle des autres cellules (non limitantes) de la batterie. Plus particulièrement, on prévoit, pour chaque cellule non limitante de la batterie, d'estimer la capacité réelle de la cellule non limitante par projection de la courbe de décharge de cette cellule sur la courbe de décharge de la cellule limitante. Cette méthode est basée sur l'hypothèse que les courbes de décharge des différentes cellules ont une forme similaire en fin de décharge. Les inventeurs ont constaté que cette hypothèse est vérifiée pour des cellules au lithium, et, plus généralement, pour toutes ou pour la plupart des autres technologies de cellules de batterie.

A titre d'illustration, dans l'exemple de la figure 1, à l'instant de fin de décharge de la batterie, c'est-à-dire lorsque la cellule limitante C1 de la batterie atteint son seuil de décharge, la cellule non limitante C2 présente à ses bornes une tension U2=f₂(Qₜₒₜ). En projetant cette tension sur la courbe de décharge 101 de la cellule limitante C1, on peut déterminer la variation de charge ΔQ_{C2} subie par la batterie entre le passage de la cellule limitante C1 à la tension U2=f₂(Qₜₒₜ) et la fin de la phase de décharge. Cette variation de charge peut s'exprimer comme suit : ΔQ_{C2} = Qₜₒₜ - f₁⁻¹(f₂(Qₜₒₜ)), où f₁⁻¹ désigne la fonction réciproque de la fonction f₁. Dans la méthode proposée, la capacité réelle de la cellule C2 est considérée comme étant égale à Qₜₒₜ + ΔQ_{C2}. Le SOH de la cellule C2 peut alors être calculé à partir de cette estimation de sa capacité réelle.

La figure 2 est un logigramme illustrant, sous forme de blocs, un exemple d'un mode de réalisation d'un procédé de détermination de l'état de santé de cellules d'une batterie mettant en oeuvre la méthode exposée ci-dessus.

On considère ici une batterie (non représentée) comportant n cellules Ci reliées en série, avec n entier supérieur à 1, par exemple n ≥ 3, et i entier allant de 1 à n.

Un outil de diagnostic (non représenté) est connecté à la batterie, cet outil comportant n capteurs de tension connectés respectivement aux bornes des n cellules de la batterie. Chaque capteur de tension est adapté à mesurer la tension Ui aux bornes de la cellule à laquelle il est associé. L'outil de diagnostic peut en outre comporter un compteur coulométrique ou un intégrateur de courant connecté à au moins une borne de la batterie, ou tout autre élément permettant de mesurer ou d'estimer la charge extraite de la batterie lors d'une phase de décharge de la batterie. L'outil de diagnostic comporte en outre des moyens de mesure et de mémorisation de l'évolution des tensions Ui aux bornes des différentes cellules en fonction de la charge Q extraite de la batterie pendant la phase de décharge. Plus particulièrement, l'outil de diagnostic est adapté à mesurer et mémoriser les courbes de décharge Ui=fᵢ(Q) des différentes cellules Ci de la batterie, fᵢ désignant la fonction régissant l'évolution de la tension Ui de la cellule Ci en fonction de la charge Q extraite de la batterie lors de la décharge de la batterie. L'outil de diagnostic peut en outre comporter une unité de traitement pouvant comporter un microprocesseur. En pratique, l'outil de diagnostic peut faire partie d'un dispositif de gestion de la batterie intégré à la batterie, généralement désigné par le terme BMS, de l'anglais "Battery Management System", destiné à mettre en oeuvre des fonctions diverses telles que des fonctions d'équilibrage des cellules, des fonctions de protection, etc. En effet, les composants susmentionnés de l'outil de diagnostic sont des composants que l'on retrouve classiquement dans un dispositif de gestion de batterie de type BMS. A titre de variante, l'outil de diagnostic peut être un dispositif externe à la batterie, destiné à être connecté à la batterie lors d'une phase de diagnostic des cellules de la batterie. Dans une autre variante, l'outil de diagnostic peut être partiellement intégré à la batterie et partiellement externe à la batterie. Par exemple, les capteurs de tension de l'outil de diagnostic peuvent être internes à la batterie, et le dispositif de traitement mettant en oeuvre la méthode décrite à partir des valeurs de tension fournies par les capteurs peut être externe à la batterie.

Le procédé de la figure 2 comprend une étape 201 au cours de laquelle la batterie soumise à une décharge complète, par exemple mais non nécessairement à courant constant. Préalablement à l'étape 201, si la batterie n'est pas déjà chargée, une étape de recharge de la batterie à son niveau de pleine charge peut être mise en oeuvre. Lors de cette recharge, un équilibrage de fin de charge est de préférence réalisé, de façon que les cellules de la batterie présentent toutes sensiblement le même niveau de tension au début de la phase de décharge complète. Les techniques susceptibles d'être utilisées pour réaliser un tel équilibrage de fin de charge sont connues de l'homme du métier et ne seront pas détaillées. Pendant la phase de décharge complète, l'outil de diagnostic mesure et mémorise l'évolution de la tension Ui aux bornes de chaque cellule Ci en fonction de la charge Q extraite de la batterie. A titre d'exemple, l'outil de diagnostic lit périodiquement, tout au long de la phase de décharge, les tensions Ui aux bornes des différentes cellules de la batterie, et stocke, à chaque lecture, les valeurs lues dans une table de mémorisation de valeurs de tension. Les tensions Ui des différentes cellules sont de préférence mesurées sous un même courant de référence i_{ref}. En effet, la tension aux bornes d'une cellule de batterie dépend en général du courant parcourant cette cellule lors de la mesure. L'outil de diagnostic peut en outre acquérir, à chaque lecture, la valeur de la charge Q extraite de la batterie depuis le début de la phase de décharge, et mémoriser cette valeur dans une table de mémorisation de valeurs de charge. A chaque lecture des valeurs de tension Ui des différentes cellules de la batterie, l'outil de diagnostic vérifie si l'une des cellules Ci n'a pas atteint son niveau de tension de fin de décharge V_{L}.

Lors d'une étape 202, lorsqu'une première cellule Ci de la batterie atteint son niveau de tension de fin de décharge V_{L}, la décharge de la batterie est interrompue. La cellule Ci ayant atteint en premier son seuil de décharge V_{L} et ayant ainsi provoqué l'arrêt de la décharge de la batterie, est identifiée par l'outil de diagnostic comme étant la cellule limitante Ciₗᵢₘ de la batterie.

Lors d'une étape 203 postérieure à l'étape 202, l'outil de diagnostic estime, pour chacune des autres cellules Ci de la batterie, la capacité réelle de la cellule Ci, à partir de la courbe de décharge de la cellule limitante Ciₗᵢₘ, selon la méthode décrite ci-dessus en relation avec la figure 1. Pour cela, l'unité de traitement de l'outil de diagnostic détermine, pour chaque cellule Ci autre que la cellule limitante Ciₗᵢₘ, la tension Ui=fᵢ(Qₜₒₜ) de la cellule à la fin de la phase de décharge complète de la batterie, puis détermine, à partir de la courbe de fin de décharge mémorisée de la cellule limitante Ciₗᵢₘ, la valeur de la charge extraite de la batterie depuis le début de la phase de décharge à l'instant de passage de la tension de la cellule limitante Ciₗᵢₘ par la valeur Ui=fᵢ(Qₜₒₜ). Cette valeur de charge est soustraite à la valeur Qₜₒₜ pour déterminer la variation de charge ΔQ_{Ci} subie par la batterie entre l'instant de passage de la cellule limitante Ciₗᵢₘ à une tension égale à la tension de fin de décharge de la cellule Ci, et la fin de la phase de décharge de la batterie. Cette valeur ΔQ_{Ci} est ensuite ajoutée à la valeur Qₜₒₜ pour obtenir une estimation de la capacité réelle de la cellule Ci. Le SOH de la cellule Ci peut alors être calculé à partir de cette estimation.

On notera que préalablement à l'étape 203, les courbes représentatives de l'évolution de la tension Ui des différentes cellules de la batterie peuvent optionnellement être lissées, par exemple en réalisant une moyenne glissante des valeurs de tension mesurées.

Un avantage de la méthode proposée est qu'elle permet d'estimer l'état de santé des différentes cellules d'une batterie à partir d'une unique phase de décharge complète de la batterie.

Cette méthode peut par exemple être mise en oeuvre par un dispositif de gestion intégré à la batterie, pendant le cycle de vie normal de la batterie, pour surveiller l'état de santé des différentes cellules de la batterie, par exemple en vue de planifier d'éventuelles opérations de maintenance de la batterie, ou pour optimiser l'utilisation de la batterie.

Une autre application de la méthode proposée concerne le diagnostic des cellules d'une batterie usagée en vue de leur revalorisation. A titre d'exemple, une fois les indicateurs d'état de santé des différentes cellules déterminés par la méthode proposée, on peut prévoir de prélever les cellules dont le SOH est supérieur à un seuil, par exemple en vue de les réassembler dans une nouvelle batterie. Les autres cellules sont par exemple recyclées par récupération des métaux les constituants. On notera que si les batteries usagées à revaloriser ne présentent pas une architecture série, ces dernières peuvent être démontées et leurs cellules réassemblées en série pour mettre en oeuvre la méthode de diagnostic décrite ci-dessus.

Une autre application de la méthode proposée concerne le diagnostic de cellules neuves préalablement à leur assemblage dans une batterie. A titre d'exemple, les cellules peuvent être montées en série lors d'une phase de diagnostic préalable à l'assemblage de la batterie. Les cellules peuvent ensuite être assemblées selon une topologie série et/ou parallèle en tenant compte des dispersions de SOH identifiées lors de la phase de diagnostic pour choisir les emplacements des différentes cellules dans la batterie.

Des modes de réalisation particuliers ont été décrits. Diverses variantes et modifications apparaîtront à l'homme de l'art. En particulier, bien que l'on ait décrit ci-dessus une méthode de diagnostic réalisée à partir d'une phase de décharge complète de la batterie, une méthode similaire peut être mise en oeuvre à partir d'une phase de charge complète de la batterie. Pour cela, la batterie peut être au préalable déchargée jusqu'à son seuil de décharge. Un équilibrage de fin de décharge peut en outre être réalisé de façon que, au début de la phase de charge complète de la batterie, les différentes cellules Ci de la batterie aient sensiblement le même niveau de tension. Pendant la phase de recharge complète de la batterie, l'outil de diagnostic peut mesurer et mémoriser l'évolution de la tension aux bornes de chaque cellule en fonction de la charge injectée dans la batterie. Lorsqu'une première cellule ou cellule limitante Ciₗᵢₘ atteint son niveau de pleine charge, correspondant par exemple à la tension maximale que peut supporter la cellule sans dégradation, la recharge de la batterie est interrompue. La charge Qₜₒₜ injectée dans la batterie depuis le début de la phase de recharge correspond alors à la capacité de la cellule Ciₗᵢₘ, qui définit la capacité de la batterie. Pour chacune des autres cellules Ci de la batterie, la capacité réelle de la cellule Ci peut être estimée à partir de la courbe de charge de la cellule limitante Ciₗᵢₘ, selon une méthode similaire à ce qui a été décrit ci-dessus. Pour cela, pour chaque cellule Ci autre que la cellule limitante Ciₗᵢₘ, la tension Ui=fᵢ(Qₜₒₜ) de la cellule à la fin de la phase de recharge complète de la batterie est déterminée, puis la variation de charge ΔQ_{Ci} subie par la batterie entre l'instant de passage de la cellule limitante Ciₗᵢₘ à la tension Ui=fᵢ(Qₜₒₜ) et la fin de la phase de recharge de la batterie est déterminée. Cette valeur ΔQ_{Ci} peut ensuite être ajoutée à la valeur Qₜₒₜ pour obtenir une estimation de la capacité réelle de la cellule Ci.

Par ailleurs, les modes de réalisation décrits ne se limitent pas aux exemples susmentionnés dans lesquels la fin de la phase de décharge complète ou de recharge complète de la batterie est conditionnée à un passage de la tension de la cellule limitante par un seuil bas (V_{L}) ou haut (non référencé sur les figures). Plus généralement, dans la méthode proposée, la décharge complète ou la charge complète de la batterie peut être interrompue dès lors qu'une condition de fin de décharge ou de fin de charge prédéfinie est satisfaite par une première cellule de la batterie. A titre d'exemple, cette condition peut être la détection d'un extrémum local observé sur la courbe de capacité incrémentale dUi/dQ de la cellule limitante, qui correspond à la dérivée d'une courbe Ui(Q) du type représenté en figure 1.

De plus, on a décrit ci-dessus des exemples de réalisation dans lesquels le diagnostic des cellules est basé sur l'analyse de l'évolution de la tension aux bornes des cellules Ci en fonction de la charge extraite de la batterie ou injectée dans la batterie lors d'une phase de décharge complète ou de recharge complète de la batterie. Ceci implique de mesurer la charge extraite de la batterie ou injectée dans la batterie au fur et à mesure de la phase de décharge ou de recharge de la batterie. A titre de variante, la méthode proposée peut être mise en oeuvre à partir de courbes représentatives de l'évolution de la tension Ui aux bornes des cellules Ci en fonction du temps. En supposant que le courant de décharge ou de charge de la batterie est sensiblement constant, on peut remonter aisément aux variations de charge de la batterie (I=ΔQ/Δt) et appliquer la méthode décrite ci-dessus.

## Revendications

1. Procédé de détermination de l'état de santé des cellules "Cᵢ" d'une batterie comportant une pluralité de cellules "Cᵢ" reliées en série, ce procédé comportant les étapes (201, 202, 203) suivantes :
pendant une phase de décharge ou de charge de la batterie, mesurer et mémoriser l'évolution de la tension "Ui" aux bornes de chaque cellule en fonction de la charge extraite ou injectée dans la batterie "Q", l'évolution de chaque tension "Ui" étant régie par une fonction "fi" de la charge "Q";
lorsque une première cellule "Ciₗᵢₘ" atteint une condition prédéfinie de fin de décharge ou de fin de charge, interrompre la décharge ou la charge de la batterie, et déterminer, pour chaque autre cellule "Ci", la variation de charge ΔQ_{Ci} subie par la batterie entre :
- le passage de la première cellule "Ciₗᵢₘ" à une tension égale à la tension "fᵢ(Qₜₒₜ)" de chaque autre cellule "Ci" à l'instant de l'interruption de la phase de décharge ou de charge de la batterie, et
- l'interruption de la phase de décharge ou de charge de la batterie; Qtot étant la charge extraite de la batterie ou injectée dans la batterie entre le début de la phase de décharge ou de charge de la batterie et l'interruption de la phase de décharge ou de charge de la batterie;
fournir, pour chaque autre cellule "Ci" de la batterie, une valeur estimée de la capacité de la cellule égale à Qₜₒₜ+ΔQ_{Ci}, et
fournir, pour chaque autre cellule "Ci" de la batterie un indicateur d'état de santé de la cellule calculé en tenant compte de ladite valeur estimée de la capacité Qₜₒₜ+ΔQ_{Ci} de la cellule.

2. Procédé selon la revendication 1, comprenant en outre :
préalablement à ladite phase de décharge, une étape de charge de la batterie jusqu'à un seuil de pleine charge ; ou
préalablement à ladite phase de charge, une étape de décharge de la batterie jusqu'à un seuil de décharge.

3. Procédé selon la revendication 2, dans lequel l'étape préalable de charge ou de décharge de la batterie comporte un équilibrage des cellules "Cᵢ" de la batterie.

4. Procédé selon l'une quelconque des revendications 1 à 3, dans lequel, lors de la phase de décharge ou de charge de la batterie, l'évolution de la charge "Q" extraite de la batterie ou injectée dans la batterie est mesurée par un dispositif de comptage de charge connecté aux bornes de la batterie.

5. Procédé selon la revendication 4, dans lequel le dispositif de comptage de charge comprend un compteur coulométrique ou un intégrateur de courant.

6. Procédé selon l'une quelconque des revendications 1 à 3, dans lequel, lors de la phase de décharge ou de charge de la batterie, l'évolution de la charge "Q" extraite de la batterie ou injectée dans la batterie est estimée à partir du temps écoulé depuis le début de la phase de décharge ou de charge et du courant de décharge de la batterie.

7. Procédé selon l'une quelconque des revendications 1 à 6, dans lequel il est tenu compte de l'évolution des températures des cellules lors de la phase de décharge ou de charge de la batterie dans la détermination de l'état de santé des cellules.

8. Procédé de revalorisation de cellules de batterie usagées comportant :
une étape de diagnostic des cellules mettant en oeuvre un procédé selon l'une quelconque des revendications 1 à 9 ; et
une étape de sélection de cellules (Ci) dont l'indicateur d'état de santé est supérieur à un seuil, et une étape d'assemblage des cellules sélectionnées en une nouvelle batterie.

## Patentansprüche

1. Verfahren zum Bestimmen des Gesundheitszustands von Zellen "Ci" einer Batterie mit einer Vielzahl von in Reihe geschalteten Zellen "Ci", wobei das Verfahren die folgenden Schritte (201, 202, 203) aufweist:
während einer Phase des Entladens oder des Ladens der Batterie, Messen und Speichern der Änderung der Spannung "Ui" über jede Zelle gemäß der aus der Batterie "Q" entnommenen oder in sie eingespeisten Ladung, wobei die Änderung jeder Spannung "Ui" durch eine Funktion "fi" der Ladung "Q" gesteuert wird;
wenn eine erste Zelle "Ciₗᵢₘ" einen vordefinierten End-Entlade- oder End-Ladezustand erreicht hat, Unterbrechen des Batterieentladens oder -ladens und Bestimmen, für jede andere Zelle "Ci", der Ladungsänderung ΔQ_{ci}, welche die Batterie durchlaufen hat, zwischen:
- dem Zeitpunkt zu dem die erste Zelle "Ciₗᵢₘ" eine Spannung durchläuft, die gleich der Spannung "fi(Qₜₒₜ)" jeder anderen Zelle "Ci" zum Zeitpunkt der Unterbrechung des Batterieentladens oder -ladens ist, und
- dem Unterbrechen der Batterieentlade- oder -ladephase; wobei Qₜₒₜ die aus der Batterie entnommene oder in die Batterie eingespeiste Ladung zwischen dem Beginn der Batterieentlade- oder -ladephase und der Unterbrechung der Batterieentlade- oder -ladephase ist;
Bereitstellen, für jede andere Zelle "Ci" der Batterie, eines geschätzten Wertes der Zellkapazität gleich Qₜₒₜ+ΔQ_{Ci}, und
Bereitstellen, für jede andere Zelle "Ci" der Batterie, eines Indikators für den Gesundheitszustand der Zelle, der unter Berücksichtigung des geschätzten Wertes der Kapazität Qₜₒₜ+ΔQ_{Ci} der Zelle berechnet wird,.

2. Verfahren nach Anspruch 1, das ferner folgendes aufweist:
vor der Entladephase einen Schritt der Batterieladung auf einen vollen Ladeschwellenwert; oder
vor der Ladephase, einen Schritt der Batterieentladung auf einen Entladeschwellenwert.

3. Verfahren nach Anspruch 2, wobei die vorherige Lade- oder Entladephase der Batterie ein Ausgleichen der Batteriezellen "Ci" umfasst.

4. Verfahren nach einem der Ansprüche 1 bis 3, wobei während der Batterielade- oder -entladephase die Änderung der aus der Batterie entnommenen oder in die Batterie eingespeisten Ladung "Q" durch eine über die Batterie angeschlossene Ladungszählvorrichtung gemessen wird.

5. Verfahren nach Anspruch 4, wobei die Ladungszählvorrichtung ein Coulometer oder einen Stromintegrator aufweist.

6. Verfahren nach einem der Ansprüche 1 bis 3, wobei während der Batterielade- oder -entladephase die Änderung der aus der Batterie entnommenen oder in die Batterie eingespeisten Ladung "Q" basierend auf der seit Beginn der Lade- oder Entladephase verstrichenen Zeit und dem Entladestrom der Batterie geschätzt wird.

7. Verfahren nach einem der Ansprüche 1 bis 6, wobei die Temperaturänderung der Zellen während der Entlade- oder Ladephase bei der Bestimmung des Gesundheitszustandes der Zellen berücksichtigt wird.

8. Verfahren zum Recycling gebrauchter Batteriezellen, das Folgendes aufweist:
einen Zelldiagnoseschritt, der das Verfahren nach einem der Ansprüche 1 bis 9 durchführt; und
einen Schritt zur Auswahl von Zellen (Ci) mit einem Gesundheitsindikator, der größer als ein Schwellenwert ist, und einen Schritt zur Montage der ausgewählten Zellen in einer neuen Batterie.

## Claims

1. A method of determining the state of health of the cells "Ci" of a battery comprising a plurality of series-coupled cells "Ci", the method comprising the steps (201, 202, 203) of:
during a phase of discharge or of charge of the battery, measuring and storing the variation of the voltage "Ui" across each cell according to the charge extracted from or injected into the battery "Q", the variation of each voltage "Ui" being ruled by a function "fᵢ" of charge "Q";
when a first cell "Ciₗᵢₘ" reaches a predefined end-of-discharge or end-of-charge condition, interrupting the battery discharge or charge and determining, for each other cell "Ci", the charge variation ΔQ_{Ci} undergone by the battery between:
- the passing of the first cell "Ciₗᵢₘ" to a voltage equal to voltage "fᵢ(Qₜₒₜ)" of each other cell "Ci" at the time of the interruption of the battery discharge or charge phase, and
- the interruption of the battery discharge or charge phase; being the charge extracted from the battery or injected into the battery between the beginning of the battery discharge or charge phase and the interruption of the battery discharge or charge phase;
supplying, for each other cell "Ci" of the battery, an estimated value of the cell capacity equal to Qₜₒₜ+ΔQ_{Ci}, and
supplying, for each other cell "Ci" of the battery, an indicator of the state of health of the cell calculated by taking into account said estimated value of the capacity Qₜₒₜ+ΔQ_{Ci} of the cell.

2. The method of claim 1, further comprising:
prior to said discharge phase, a step of battery charge to a full charge threshold; or
prior to said charge phase, a step of battery discharge to a discharge threshold.

3. The method of claim 2, wherein the prior battery charge or discharge phase comprises a balancing of the battery cells "Ci".

4. The method of any of claims 1 to 3, wherein, during the battery charge or discharge phase, the variation of the charge "Q" extracted from the battery or injected into the battery is measured by a charge counting device connected across the battery.

5. The method of claim 4, wherein the charge counting device comprises a coulometer or a current integrator.

6. The method of any of claims 1 to 3, wherein, during the battery charge or discharge phase, the variation of the charge "Q" extracted from the battery or injected into the battery is estimated based on the time elapsed since the beginning of the discharge or charge phase and on the battery discharge current.

7. The method of any of claims 1 to 6, wherein the temperature variation of the cells during the discharge or charge phase is taken into account in the determination of the state of health of the cells.

8. A method of recycling used battery cells comprising:
a cell diagnosis step implementing the method of any of claims 1 to 9; and
a step of selection of cells (Ci) having a state-of-health indicator greater than a threshold, and a step of assembling the selected cells in a new battery.
